# EUROPEAN PATENT APPLICATION

(11) **EP 4 657 516 A1**
(43) Date of publication of application: **03.12.2025**
(21) Application number: 24747414.1
(22) Date of filing: 19.01.2024
(51) Int. Cl.: H01L 23/00, H01L 23/492

(54) **CONDUCTIVE PASTE AND BONDING METHOD USING SAME**

(30) Priority: 27.01.2023 KR 20230010801
(71) Applicant: Amogreentech Co., Ltd., Gimpo-si, Gyeonggi-do 10014 (KR)
(72) Inventor: MAENG, Jaehoon, Gimpo-si, Gyeonggi-do 10014 (KR)
(74) Representative: Zimmermann, Tankred Klaus
(86) International application number: PCT/KR2024/000989
(87) International publication number: WO 2024/158177

(57) **Abstract**

The present invention relates to a conductive paste and a bonding method using same. The conductive paste comprises: silver powder; and a binder, wherein the silver powder includes first to fourth silver particle groups. Here, the first silver particle group, the second silver particle group, and the third silver particle group are groups of flake-shaped particles with different average particle diameters (D50) and different average aspect ratio ranges, and the fourth silver particle group is composed of a group of spherical particles, such that it is possible to manufacture an assembly with high shear strength even under low pressure conditions.

## Description

### [Technical Field]

Embodiments of the present disclosure relate to a conductive paste and a bonding method using the same, and more particularly, to a conductive paste used to electrically connect electronic components such as a substrate and a semiconductor chip, and a bonding method using the conductive paste.

### [Background Art]

Power semiconductor chips using SiC or the like have characteristics of being operable even at high temperatures of 300°C or higher. In the case where the power semiconductor chips operate at high temperatures, conventional solders having a heat resistance temperature of about 150°C are not suitable as bonding materials. Accordingly, use of a conductive paste in which fine metal particles having excellent heat resistance and electrical conductivity are dispersed in a solvent has been under consideration.

However, in the case where a substrate and a semiconductor device are bonded at a high temperature using a conductive paste, a solvent may volatilize during a bonding process, which may result in the formation of a large void in a bonding region, thereby making it difficult to bond the semiconductor device to the substrate with high strength.

To overcome the aforementioned problem, a method has been employed, in which a substrate and a semiconductor device are bonded at a high temperature while applying pressure to a conductive paste layer formed on the substrate. However, there remains a problem in that the shear strength of the resulting bonded structure is insufficient.

The contents described in the Background Art are to help the understanding of the background of the disclosure, and may include contents that are not a disclosed conventional technology.

### [Summary of Invention]

### [Technical Problem]

The present disclosure has been devised to solve the above problem, and various embodiments of the present disclosure are directed to a conductive paste and a bonding method using the same, which enable a semiconductor device to be bonded to a substrate with high strength when the conductive paste is applied to a surface of the substrate and heated.

### [Solution to Problem]

A conductive paste according to an embodiment of the present disclosure for achieving the aforementioned object may include a conductive paste comprising silver powder and a binder. The silver powder may include a first silver particle group, a second silver particle group, a third silver particle group, and a fourth silver particle group. The first silver particle group, the second silver particle group, and the third silver particle group may be flake-shaped particle groups respectively having different average particle diameters (D50) and different average aspect ratio ranges. The fourth silver particle group may be a spherical particle group.

The average particle diameter (D50) of the first silver particle group may range from 0.3 µm to 0.5 µm. The average particle diameter (D50) of the second silver particle group may range from 0.7 µm to 0.9 µm. The average particle diameter (D50) of the third silver particle group may range from 1.2 µm to 1.8 µm. The average particle diameter (D50) of the fourth silver particle group may range from 0.2 µm to 0.4 µm.

The first silver particle group may have an average aspect ratio in a range from 2 to 3. The second silver particle group may have an average aspect ratio in a range from 3 to 5. The third silver particle group may have an average aspect ratio in a range from 4 to 6.

The first silver particle group may be included in an amount ranging from 10 wt% to 20 wt% based on a total weight of the silver powder. The second silver particle group may be included in an amount ranging from 25 wt% to 30 wt% based on the total weight of the silver powder. The third silver particle group may be included in an amount ranging from 30 wt% to 35 wt% based on the total weight of the silver powder. The fourth silver particle group may be included in an amount ranging from 25 wt% to 35 wt% based on the total weight of the silver powder.

The silver powder may be included in an amount ranging from 75 wt% to 90 wt% based on a total weight.

The binder may be included in an amount ranging from 0.5 wt% to 1.5 wt% relative to a total weight of the silver powder.

The conductive paste may further include a solvent formed of at least one of alcohol or acetate. The solvent may be included in an amount ranging from 5 wt% to 20 wt% relative to a weight of the silver powder.

The conductive paste may further include an additive formed of at least one of organic acid and organic base. The additive may be included in an amount ranging from 0.2 wt% to 1 wt% relative to a weight of the silver powder.

A bonding method using a conductive paste may include forming a paste layer by placing the conductive paste produced according to claim 1 on a first object, forming a stacked structure by stacking a second object on the paste layer, and forming a bonded structure by heating the stacked structure and sintering the paste layer.

The forming of the bonded structure may include heating the paste layer while a pressure ranging from 10 MPa to 15 MPa is applied to the paste layer.

In the forming of the bonded structure, the sintering may be performed at a temperature ranging from 250°C to 300°C for a time ranging from 2 minutes to 5 minutes.

### [Advantageous Effects of Invention]

A conductive paste according to the present disclosure may include first to third silver particle groups having flake-shaped particles with different average particle diameters and different average aspect ratio ranges, and a fourth silver particle group having spherical particles, thereby enabling the production of a bonded structure having high shear strength even under a low pressure condition.

Furthermore, according to the conductive paste of the present disclosure, a power semiconductor chip may be bonded with high strength even when no additional plating is applied to a metal layer of an active metal brazed (AMB) substrate. Surface contact between the particles may enable effective formation of conduction paths, thereby exhibiting excellent electrical conductivity.

### [Brief Description of Drawings]

FIG. 1 is a cross-sectional view illustrating a bonded structure formed using a conductive paste according to an embodiment of the present disclosure.
FIG. 2 is a flowchart for explaining a bonding method using the conductive paste according to an embodiment of the present disclosure.
FIG. 3 is a block diagram for explaining the bonding method using the conductive paste according to an embodiment of the present disclosure.

### [Description of Embodiments]

Hereinafter, various embodiments of the present disclosure are described in detail with reference to the accompanying drawings.

Embodiments are provided to more fully explain the present disclosure to a person having ordinary knowledge in the art to which the present disclosure pertains. The following embodiments may be modified in various other forms, and the scope of the present disclosure is not limited to the following embodiments. Rather, these embodiments are provided to make the present disclosure more thorough and complete and to fully convey the spirit of the present disclosure.

Terms used in this specification are used to describe a specific embodiment, and are not intended to limit the present disclosure. Furthermore, in this specification, an expression of the singular number may include an expression of the plural number unless clearly defined otherwise in the context.

The drawings are merely for enabling the spirit of the present disclosure to be understood, and it should not be interpreted that the scope of the present disclosure is limited by the drawings. Furthermore, in the drawings, a relative thickness or length or a relative size may be enlarged for convenience and the clarity of description.

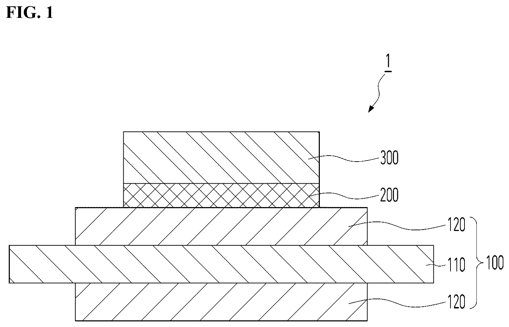

Although it will be described below with reference to FIGS. 1 to 3, a conductive paste according to an embodiment of the present disclosure may serve as a conductive adhesive provided to bond a power semiconductor chip to an active metal brazed (AMB) substrate. The conductive paste may be configured to include silver powder and a binder. Here, the conductive paste may include gold (Au) powder; however, in terms of cost, it is desirable to use silver (Ag) powder.

The silver powder may be in the form of a combination of flake-shaped particles and spherical particles. Preferably, the silver powder includes a first silver particle group, a second silver particle group, a third silver particle group, and a fourth silver particle group. Here, the first to third silver particle groups may be formed of flake-shaped particles, and the fourth silver particle group may be formed of spherical particles. A method of manufacturing the silver powder is not particularly limited and may be performed, for example, by a reduction method, a crushing method, an electrolysis method, an atomization method, a heat treatment method, or a combination thereof. Flake-shaped silver particles may be manufactured, for example, by crushing spherical or granular silver particles using a ball mill or the like.

An average particle diameter of the first to fourth silver particle groups employs a median diameter (D50) value. The average particle diameter (D50) refers to a particle diameter at a point where a cumulative volume reaches 50% on a cumulative curve in a cumulative particle size distribution according to a particle size distribution system. An average particle diameter (D50) of the first silver particle group may range from 0.3 µm to 0.5 µm, an average particle diameter (D50) of the second silver particle group may range from 0.7 µm to 0.9 µm, and an average particle diameter (D50) of the third silver particle group may range from 1.2 µm to 1.8 µm. As such, the first silver particle group, the second silver particle group, and the third silver particle group may be flake-shaped particle groups having different average particle diameters (D50) and different average aspect ratio ranges. In addition, an average particle diameter (D50) of the fourth silver particle group, which corresponds to a spherical shape, may range from 0.2 µm to 0.4 µm.

Preferably, the silver powder may include the first silver particle group ranging from 10 wt% to 20 wt%, the second silver particle group ranging from 25 wt% to 30 wt%, the third silver particle group ranging from 30 wt% to 35 wt%, and the fourth silver particle group ranging from 25 wt% to 35 wt%, based on a total weight of the silver powder.

In the case where each of the first to fourth silver particle groups is included within the above-described range in the silver powder, the effect of forming a dense aggregate having small gaps between silver particles during sintering of the conductive paste may be enhanced. Accordingly, a bonding layer having a reduced number of voids and high shear strength may be formed.

The silver powder may be included in a range from 75 wt% to 90 wt% based on a total weight of the conductive paste. When the content of the silver powder is less than 75 wt% based on the total weight, it is difficult to ensure electrical conductivity, and when the content of the silver powder exceeds 90 wt%, it is difficult to achieve adhesion due to a relatively insufficient content of the solvent and the binder.

The binder allows the conductive paste to have excellent bonding strength and enables the silver powder to be uniformly applied. The binder controls the spreadability of the paste, thereby enabling control of the coating thickness. An acrylic-based polymer may be used as the binder. For example, the binder may include acrylate, polyethylene glycol, and the like. The binder may be included in a range from 0.5 wt% to 1.5 wt% based on the weight of the silver powder. When the content of the binder is less than 0.5 wt% based on the weight of the silver powder, it is difficult for the silver powder to be uniformly distributed, and when the content of the binder exceeds 1.5 wt%, it is difficult to ensure the electrical conductivity.

The conductive paste according to an embodiment of the present disclosure may include a solvent. The solvent adjusts the viscosity of the binder to impart flowability to the conductive paste. An alcohol-based solvent, an acetate-based solvent, or the like may be used as the solvent. For example, the alcohol-based solvent may include terpineol, isopropyl alcohol, ethyl hexanediol, 1-hexanol, and 1-octanol, and the acetate-based solvent may include butyl carbitol acetate and the like. Preferably, the solvent is included in a range from 5 wt% to 20 wt% based on the weight of the silver powder. If the solvent is included in an amount less than 5 wt% based on the weight of the silver powder, it is difficult to uniformly disperse the paste, and if the content of the solvent exceeds 20 wt%, it may be difficult to ensure bonding strength due to a relatively insufficient content of the binder.

The conductive paste may include an additive. An organic acid, an organic base, or the like may be used as the additive. For example, the additive may include ascorbic acid, formic acid, tartaric acid, or the like. Such an organic additive may be easily decomposed or volatilized when the conductive paste is heated after being applied to the bonding surface, thereby exposing surfaces of highly active portions in the first to fourth silver particle groups, and having an effect of facilitating a sintering reaction among the first to fourth silver particle groups. In addition, the organic additive may have a reducing capability to reduce an oxide film on the bonding surface. The additive may be included in a range from 0.2 wt% to 1 wt% based on the weight of the silver powder. If the additive is included beyond the foregoing range, an organic substance may remain in the bonding layer and may be decomposed over time, thereby forming voids in the bonding layer. Accordingly, it is preferable that the additive be included in a range from 0.2 wt% to 1 wt% when the total amount of the first to fourth silver particle groups is set to 100 wt%.

The conductive paste may be formed in a region of the AMB substrate where a power semiconductor chip is to be bonded, and, in this case, a method such as a metal mask method, screen printing, stencil printing, or jetting may be used.

The conductive paste may be interposed between the AMB substrate and the power semiconductor chip and sintered, thereby bonding the AMB substrate and the power semiconductor chip. The sintering of the conductive paste may be performed at a temperature of 250°C to 300°C for 2 minutes to 5 minutes. Preferably, the sintering may be performed at 250°C for 2 minutes and 30 seconds. Compared to a conventional conductive paste, the conductive paste according to the present disclosure may exhibit improved bonding strength.

Hereinafter, the present disclosure will be described with reference to embodiments. However, the present disclosure is not limited to the following embodiments.

### Embodiment 1

A conductive paste was obtained, which includes silver powder formed of first to third silver particle groups having flake-shaped particles and a fourth silver particle group having spherical particles, a binder, a solvent, and an organic additive. In the conductive paste of Embodiment 1, based on the total weight of the silver powder, 15 wt% of the first silver particle group, 25 wt% of the second silver particle group, 30 wt% of the third silver particle group, and 30 wt% of the fourth silver particle group were included.

In a cumulative particle size distribution based on the particle size distribution system, when a particle diameter at a point where the cumulative volume reaches 50% on the cumulative curve is referred to as D50, the first silver particle group has a D50 ranging from 0.3 µm to 0.5 µm, and an average aspect ratio ranging from 2 to 3; the second silver particle group has a D50 ranging from 0.7 µm to 0.9 µm, and an average aspect ratio ranging from 3 to 5; the third silver particle group has a D50 ranging from 1.2 µm to 1.8 µm, and an average aspect ratio ranging from 4 to 6; and the fourth silver particle group has a D50 ranging from 0.2 µm to 0.4 µm.

In the conductive paste of Embodiment 1, the binder was included in an amount of 1 wt% based on the weight of the silver powder, the solvent was included in an amount of 20 wt% based on the weight of the silver powder, and the additive was included in an amount of 0.5 wt% based on the weight of the silver powder.

### Embodiment 2

In Embodiment 2, based on the total weight of the silver powder, 10 wt% of the first silver particle group, 25 wt% of the second silver particle group, 30 wt% of the third silver particle group, and 35 wt% of the fourth silver particle group were included in the conductive paste.

### Embodiment 3

In Embodiment 3, based on the total weight of the silver powder, 20 wt% of the first silver particle group, 25 wt% of the second silver particle group, 30 wt% of the third silver particle group, and 25 wt% of the fourth silver particle group were included in the conductive paste.

### Comparative example 1

In Comparative Example 1, based on the total weight of the silver powder, 100 wt% of the fourth silver particle group was included in the conductive paste.

### Comparative example 2

In Comparative Example 2, based on the total weight of the silver powder, 70 wt% of the second silver particle group and 30 wt% of the fourth silver particle group were included in the conductive paste.

### Comparative example 3

In Comparative Example 3, based on the total weight of the silver powder, 15wt% of the first silver particle group, 25 wt% of the second silver particle group, 50 wt% of the third silver particle group, and 10 wt% of the fourth silver particle group were included in the conductive paste.

### Fabrication and Evaluation of Bonded Structure

Referring to FIG. 1, an AMB substrate 100 having a ceramic base 110 and a metal layer 120 was prepared, and a conductive paste was applied to a surface of the metal layer 120 of the AMB substrate 100 by a metal mask method to form a paste layer 200. Evaluation 1 is an evaluation of the shear strength of a bonded structure 1, which was formed by stacking a power semiconductor chip 300 on the paste layer 200 to form a stacked structure, and heating the stacked structure at 250°C under a pressure of 10 MPa for 150 seconds. Evaluation 2 is an evaluation of the shear strength of a bonded structure 1, which was formed by sintering under a pressing condition different from the pressing condition of Evaluation 1. In Evaluation 2, a stacked structure in which the power semiconductor chip 300 was stacked on the paste layer 200 was sintered under a pressure of 15 MPa to produce the bonded structure 1. Here, the power semiconductor chip 300 had a size of 5 mm × 5 mm and was plated with Ag (Ag-finished). The Ag plating was intended to enhance adhesion with the silver powder, which is a component of the conductive paste according to the present disclosure.

The shear strength of the bonded structure 1 was measured as the shear strength (MPa) between the AMB substrate 100 and the power semiconductor chip 300 using a shear strength tester for each obtained bonded structure. For each sample, the measurement was performed five times, and the average of the results of the measurement was used as a measured value of the shear strength. The determination result of the shear strength was made based on a criterion of 50 MPa, and the determination result is shown in Table 1.

**[Table 1]**

| | | Conductive Particles | | | | Binder (relative to silver powder) | Solvent (relative to silver powder) | Additive (relative to silver powder) | Evaluation 1 | | Evaluation 2 | |
|---|---|---|---|---|---|---|---|---|---|---|---|---|
| | | First Particle Group | Second Particle Group | Third Particle Group | Fourth Particle Group | | | | | | | |
| Average Particle Diameter(D50) | | 0.3µm to 0.5 µm | 0.7µm to 0.9 µm | 1.2µm to 1.8 µm | 0.2µm to 0.4 µm | | | | | | | |
| Aspect Ratio | | 2 to 3 | 3 to 5 | 4 to 6 | - | | | | Shear Strength (10MPa) | Determin ation Result | Shear Strength (15Mpa) | Determin ation Result |
| Embodim ent 1 | (wt %) | 15 | 25 | 30 | 30 | 1 | 20 | 0.5 | 60 | O | 68 | O |
| Embodim ent 2 | (wt %) | 10 | 25 | 30 | 35 | 1 | 20 | 0.5 | 53 | O | 64 | O |
| Embodim ent 3 | (wt %) | 20 | 25 | 30 | 25 | 1 | 20 | 0.5 | 50 | O | 59 | O |
| Comparat ive Ex. 1 | (wt %) | 0 | 0 | 0 | 100 | 1 | 20 | 0.5 | 46 | X | 49 | O |
| Comparat ive Ex. 2 | (wt %) | 0 | 70 | 0 | 30 | 1 | 20 | 0.5 | 36 | X | 51 | O |
| Comparat ive Ex. 3 | (wt %) | 15 | 25 | 50 | 10 | 1 | 20 | 0.5 | 40 | X | 57 | O |

Referring to the results shown in Table 1, in the cases of Embodiments 1 to 3, which include all of the first to third silver particle groups having flake-shaped particles with different average particle diameters (D50) and different average aspect ratio ranges and the fourth silver particle group having spherical particles, it can be seen that a dense aggregate with small gaps between particles is formed during sintering, and thus bonded structures having a high shear strength of 50 MPa or more can be produced even under a low pressure condition of 10 MPa. In particular, in the case of Embodiment 1, the shear strength of the bonded structure is the highest at 60 MPa, so that it can be understood that the composition in Embodiment 1 is optimal.

When the results of Evaluation 1 and Evaluation 2 are compared, it can be understood that a bonded structure produced under a pressure condition of 15 MPa, which is higher than 10 MPa, may have higher shear strength. However, sintering under such a high-pressure condition has a disadvantage in that the process becomes more complex and costly. Accordingly, the present disclosure is intended to provide a composition capable of producing a bonded structure having a high shear strength of 50 MPa or more while reducing cost. As shown in the results of Table 1, it can be understood that when all of the first to third silver particle groups having flake-shaped particles with different average particle diameters (D50) and different average aspect ratio ranges and the fourth silver particle group having spherical particles are included, a high shear strength of 50 MPa or more can be achieved even under a low pressure condition of 10 MPa.

In contrast, when only the fourth silver particle group having spherical particles is included as in Comparative Example 1, sintering is possible even under the pressure condition of 10 MPa, but the shear strength of the bonded structure cannot exceed 46 MPa due to the limitation of the strength of the sintered layer. In addition, when only the fourth silver particle group having spherical particles and the second silver particle group as a flake-shaped particle group are included as in Comparative Example 2, sintering is not satisfactorily achieved even under the pressure condition of 10 MPa, and the shear strength of the bonded structure was as low as 36 MPa.

In the case of Comparative Example 3, although all of the first to third silver particle groups having flake-shaped particles with different average particle diameters (D50) and different average aspect ratio ranges, and the fourth silver particle group having spherical particles are included, the conductive paste of Comparative Example 3 includes 50 wt% of the third silver particle group and 10 wt% of the fourth silver particle group based on the total weight of the silver powder, which significantly deviates from the compositional range of the present disclosure. As a result, the shear strength was as low as 40 MPa. Accordingly, it is preferable that the conductive paste include the first silver particle group in a range from 10 wt% to 20 wt%, the second silver particle group in a range from 25 wt% to 30 wt%, the third silver particle group in a range from 30 wt% to 35 wt%, and the fourth silver particle group in a range from 25 wt% to 35 wt%, based on the total weight of the silver powder.

As described above, the silver powder in the conductive paste of the present disclosure includes the first to third silver particle groups having flake-shaped particles and the fourth silver particle group having spherical particles, and the first to third silver particle groups are formed of flake-shaped particle groups having different average particle diameters (D50) and different average aspect ratio ranges, thereby exhibiting a relatively broad particle size distribution.

Accordingly, when the silver powder precipitates on the surface of the substrate, relatively small particles are interposed between larger particles, so that the gaps between the particles become small and dense, thereby forming a paste layer having reduced voids and high shear strength. In addition, surface contact between the particles facilitates the formation of conduction paths, thereby exhibiting excellent electrical conductivity.

In addition, when the conductive paste of the present disclosure is used, the power semiconductor chip may be bonded to the AMB substrate with high strength even in a state where the metal layer of the AMB substrate is not separately plated. Furthermore, the conductive paste enables bonding under high-temperature conditions (for example, 300°C or higher), which has been difficult to achieve using conventional bonding materials, and is therefore useful as a bonding material for power semiconductor chips.

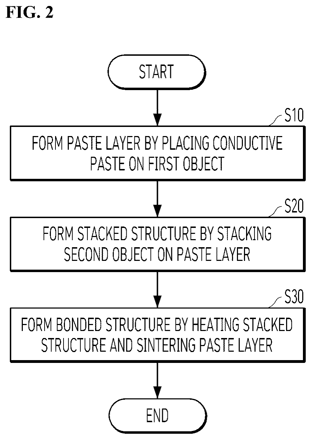

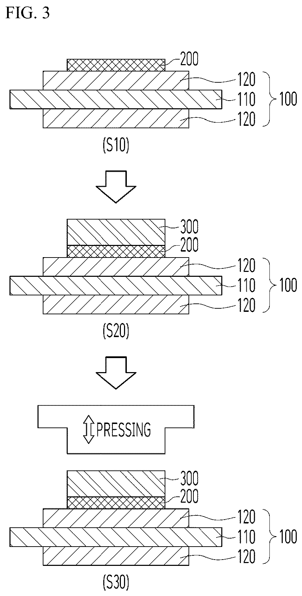

FIG. 2 is a flowchart for explaining a bonding method using the conductive paste according to an embodiment of the present disclosure. FIG. 3 is a block diagram for explaining the bonding method using the conductive paste according to an embodiment of the present disclosure.

As shown in FIGS. 2 and 3, the bonding method using the conductive paste may include: step S10 of forming a paste layer by placing the conductive paste according to an embodiment of the present disclosure on a first object, step S20 of forming a stacked structure by stacking a second object on the paste layer, and step S30 of forming a bonded structure by heating the stacked structure such that the paste layer is sintered. Here, the first object may be the AMB substrate 100, and the second object may be the power semiconductor chip 300. To improve dissipation efficiency of heat generated from a semiconductor device, the AMB substrate 100 may include a ceramic base 110, and a metal layer 120 that is brazed to at least one surface of the ceramic base 110 and may be made of copper or a copper alloy. The power semiconductor chip 300 may be any one of a Si chip, a SiC chip, or a GaN chip.

In step S10 of forming the paste layer, a method such as a metal mask method, screen printing, stencil printing, or jetting may be used to form the paste layer 200 by placing the conductive paste on the AMB substrate 100.

In step S20 of forming the stacked structure, the power semiconductor chip 300 may be adsorbed in a vacuum and placed on an upper portion of the paste layer 200 located on an upper surface of the AMB substrate 100.

In step S30 of forming the bonded structure, the power semiconductor chip 300 may be bonded to the AMB substrate 100 by sintering while pressing the power semiconductor chip 300 toward the AMB substrate 100. The sintering may be performed at a temperature ranging from 250°C to 300°C for 2 to 5 minutes. Preferably, the sintering may be performed at 250°C for 2 minutes and 30 seconds. The pressure applied to the paste layer 200 may range from 10 MPa to 15 MPa. The pressure sintering may minimize voids when the power semiconductor chip 300 is bonded to the substrate 100, thereby facilitating formation of conduction paths, and shortening the sintering time to improve process efficiency.

As described above, the conductive paste may be interposed between the AMB substrate and the power semiconductor chip and may bond the AMB substrate and the power semiconductor chip to each other through sintering. The conductive paste of the present disclosure includes the first to third silver particle groups having flake-shaped particles with different average particle diameters and different average aspect ratio ranges and the fourth silver particle group having spherical particles, thereby forming a dense structure with small gaps between particles. As a result, a bonded structure having a reduced number of voids and high shear strength may be formed.

The above description is merely an illustrative description of the technical spirit of the present disclosure, and those skilled in the art may change and modify the present disclosure in various ways without departing from the essential characteristic of the present disclosure. Accordingly, the embodiments described in the present disclosure should not be construed as limiting the technical spirit of the present disclosure, but should be construed as describing the technical spirit of the present disclosure. The technical spirit of the present disclosure is not restricted by the embodiments. The range of protection of the present disclosure should be construed based on the following claims, and all of technical spirits within an equivalent range of the present disclosure should be construed as being included in the scope of rights of the present disclosure.

## Claims

1. A conductive paste comprising silver powder and a binder,
wherein the silver powder includes a first silver particle group, a second silver particle group, a third silver particle group, and a fourth silver particle group,
wherein the first silver particle group, the second silver particle group, and the third silver particle group are flake-shaped particle groups respectively having different average particle diameters (D50) and different average aspect ratio ranges, and
wherein the fourth silver particle group is a spherical particle group.

2. The conductive paste of claim 1,
wherein the average particle diameter (D50) of the first silver particle group ranges from 0.3 µm to 0.5 µm,
wherein the average particle diameter (D50) of the second silver particle group ranges from 0.7 µm to 0.9 µm,
wherein the average particle diameter (D50) of the third silver particle group ranges from 1.2 µm to 1.8 µm, and
wherein the average particle diameter (D50) of the fourth silver particle group ranges from 0.2 µm to 0.4 µm.

3. The conductive paste of claim 1,
wherein the first silver particle group has an average aspect ratio in a range from 2 to 3,
wherein the second silver particle group has an average aspect ratio in a range from 3 to 5,
wherein the third silver particle group has an average aspect ratio in a range from 4 to 6.

4. The conductive paste of claim 1,
wherein the first silver particle group is included in an amount ranging from 10 wt% to 20 wt% based on a total weight of the silver powder,
wherein the second silver particle group is included in an amount ranging from 25 wt% to 30 wt% based on the total weight of the silver powder,
wherein the third silver particle group is included in an amount ranging from 30 wt% to 35 wt% based on the total weight of the silver powder, and
wherein the fourth silver particle group is included in an amount ranging from 25 wt% to 35 wt% based on the total weight of the silver powder.

5. The conductive paste of claim 1, wherein the silver powder is included in an amount ranging from 75 wt% to 90 wt% based on a total weight.

6. The conductive paste of claim 1, wherein the binder is included in an amount ranging from 0.5 wt% to 1.5 wt% relative to a total weight of the silver powder.

7. The conductive paste of claim 1, further comprising a solvent formed of at least one of alcohol or acetate,
wherein the solvent is included in an amount ranging from 5 wt% to 20 wt% relative to a weight of the silver powder.

8. The conductive paste of claim 1, further comprising an additive formed of at least one of organic acid and organic base,
wherein the additive is included in an amount ranging from 0.2 wt% to 1 wt% relative to a weight of the silver powder.

9. A bonding method using a conductive paste, comprising:
forming a paste layer by placing the conductive paste produced according to claim 1 on a first object;
forming a stacked structure by stacking a second object on the paste layer; and
forming a bonded structure by heating the stacked structure and sintering the paste layer.

10. The bonding method of claim 9, wherein the forming of the bonded structure comprises heating the paste layer while a pressure ranging from 10 MPa to 15 MPa is applied to the paste layer.

11. The bonding method of claim 9,
wherein the first object is a substrate, and
wherein the second object is a power semiconductor chip.

12. The bonding method of claim 9, wherein in the forming of the bonded structure, the sintering is performed at a temperature ranging from 250°C to 300°C for a time ranging from 2 minutes to 5 minutes.
